(19) 

Europäisches Patentamt
European Patent Office
Office européen des brevets

(11) **EP 4 506 158 A1**

(12) **EUROPEAN PATENT APPLICATION**
published in accordance with Art. 153(4) EPC

(43) Date of publication:
**12.02.2025 Bulletin 2025/07**

(21) Application number: **23784701.7**

(22) Date of filing: **30.03.2023**

(51) International Patent Classification (IPC):
**B32B 9/00** (2006.01)    **C23C 14/08** (2006.01)

(52) Cooperative Patent Classification (CPC):
**B32B 9/00; C23C 14/08**

(86) International application number:
**PCT/JP2023/013294**

(87) International publication number:
**WO 2023/195414 (12.10.2023 Gazette 2023/41)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **05.04.2022 JP 2022062769**

(71) Applicant: **Toyobo Co., Ltd.**
**Kita-ku**
**Osaka-shi, Osaka 530-0001 (JP)**

(72) Inventor: **ISEKI, Kiyoshi**
**Inuyama-shi, Aichi 484-8508 (JP)**

(74) Representative: **Vossius & Partner**
**Patentanwälte Rechtsanwälte mbB**
**Siebertstrasse 3**
**81675 München (DE)**

(54) **TRANSPARENT GAS BARRIER FILM**

(57)    The purpose of the present invention is to provide an inexpensive transparent gas barrier film with excellent acid resistance. The present invention is a transparent gas barrier film that is a plastic film having, on at least one surface of the plastic film, an aluminum oxide layer comprising aluminum oxide as a main component, the transparent gas barrier film characterized in that an absorption coefficient of the aluminum oxide layer at a wavelength of 350 nm immediately after vapor deposition is $8.0 \times 10^{-4}$ nm$^{-1}$ to $4.0 \times 10^{-3}$ nm$^{-1}$, and the unchanged amount of the absorption coefficient is $3.0 \times 10^{-4}$ nm$^{-1}$ or less at a film thickness of 6 nm to 20 nm.

Fig.1

EP 4 506 158 A1

**Description**

TECHNICAL FIELD

The present invention relates to a transparent barrier film having excellent properties as a packaging material that has excellent transparency, gas barrier properties, printability, and flexibility and is required to provide the airtightness of foods, pharmaceuticals, and electronic components and the like, or a gas blocking material.

BACKGROUND ART

As a transparent barrier film, a film obtained by laminating an inorganic substance on a plastic film is used. As the inorganic substance, metal oxides such as silicon oxide and aluminum oxide are often used from the viewpoint of transparence. In particular, among metal oxides, films obtained by laminating silicon oxide, aluminum oxide, and a mixture thereof by a vapor-deposition method or a CVD method are mainly commercially available.

In particular, a laminated film that includes, as a barrier layer, an aluminum oxide layer formed by a reactive vapor-deposition method of evaporating aluminum and introducing oxygen is mainly used (See, for example, Patent Document 1).

The following transparent barrier film is also commercially available. On the transparent barrier film, an inorganic layer is laminated, and the inorganic layer is coated with an organic layer or the like to improve the barrier properties of the film or protect the inorganic layer (see, for example, Patent Document 2).

The transparent barrier film is used in a state where the film is subjected to printing when used for a packaging material, or other film is laminated on the film using an adhesive or the like. Various films are laminated, but an un-stretched polyethylene film or polypropylene film called a sealant is generally laminated in order to make a bag.

However, when acidic contents are put into a bag made of a barrier film on which aluminum oxide is laminated and stored for a long period of time, there is a problem in that the acid component reacts with the aluminum oxide layer to deteriorate the barrier properties, so that entry of oxygen and evaporation or entry of moisture are allowed and degradation of the contents proceeds.

Patent Document 1 discloses a production method in which sufficient barrier properties are less likely to be obtained with 100 nm or less in a reactive vapor-deposition method in which aluminum is evaporated and oxygen is blown, whereby vapor-deposition is performed under a pressure of $1 \times 10^{-5}$ to $1 \times 10^{-2}$ Torr ($1.33 \times 10^{-3}$ to 1.33 Pa) in a vacuum pressure vessel, and the film is then stored under conditions of 40°C and 80% RH, or immersed in warm water to temporarily adsorb moisture, followed by performing a heat treatment.

In the production method, it is considered that the barrier properties can be improved, but unreacted aluminum is combined with water to form aluminum hydroxide, whereby the aluminum hydroxide is apt to react with an acid.

Patent Document 2 discloses a production method in which a vapor-deposited inorganic oxide layer having an ultraviolet transmittance (366 nm) of 82 to 94% is provided, and a coating layer is provided thereon by a sol-gel method.

In the production method, the film thickness is 10 nm or more, whereby the ultraviolet transmittance of 82% or less is considered to cause poor transparency, and the ultraviolet transmittance of 94% or more is considered to provide no reactivity with the coating layer. In the production method, the degree of oxidation during vapor-deposition is increased to provide improved transparency, thereby causing the coating layer to improve the barrier properties. The production method increases the number of steps, which makes it difficult to inexpensively produce the film. When an oxide layer obtained by oxidizing aluminum is used, the coating layer cannot prevent a reaction due to an acid.

Therefore, for coping, there is used a barrier layer composed of silicon oxide as an expensive vapor-deposition material, or a vapor-deposition material using a layer formed by an expensive vapor-deposition apparatus using an electron beam vapor-deposition source and obtained by mixing silicon oxide with aluminum oxide.

Patent Document 3 describes that when aluminum oxide is vapor-deposited, incomplete aluminum oxide rather than complete oxide is vapor-deposited under an atmosphere in which argon gas exists to form a film having a slightly low density, and the film is exposed to the atmosphere and aged in a short time to form a transparent barrier film. However, in Patent Document 3, it is described that the film is colorless and transparent with a light transmittance of 350 nm and 550 nm of 70% after vapor-deposition at a thickness of 7 nm, which is in a state of strong coloration, and with a low level of 80% even after aging, but when the color difference is measured, the b value is high, and it is estimated that the film is yellow.

There is a description that the film density is lowered and aging is performed in a short time, but it is estimated that the film is in a state of insufficient oxidation. It is presumed that in a film having a low density, an acid easily penetrates into the film, and improvement in acid resistance cannot be expected.

As a measure for this improvement, the present inventor has proposed a transparent gas barrier film in which an absorption coefficient of an aluminum oxide layer immediately after vapor-deposition is less than 0.03 nm-1 and a film thickness is 6 nm or more and 10 nm or less, the absorption coefficient being obtained from a total light transmittance (see Patent Document 4).

It was confirmed that the resistance was improved so that the barrier performance was not deteriorated against an acid.

PRIOR ART DOCUMENTS

PATENT DOCUMENTS

Patent Document 1: JP-B-02638797
Patent Document 2: JP-A-2007-290292
Patent Document 3: JP-A-2007-2325
Patent Document 4: WO2020/241621

SUMMARY OF THE INVENTION

PROBLEMS TO BE SOLVED BY THE INVENTION

The present inventor has paid attention to the fact that the acid resistance of the aluminum oxide produced by reactive vapor-deposition is related to the light absorption coefficient of the aluminum oxide layer, and has improved the acid resistance by controlling the light absorption coefficient. In Patent Document 4, attention is paid to the total light transmittance, and the light absorption coefficient is calculated to attempt to improve the acid resistance, but the acid resistance cannot be sufficiently improved when the film thickness of the aluminum oxide layer is 10 nm or more. Even when the film thickness is 10 nm or less, the acid resistance of the transparent gas barrier film on which alumina-silica is vapor-deposited is not achieved. The invention of the present application provides a transparent barrier film having an aluminum oxide layer with further improved acid resistance.

MEANS FOR SOLVING THE PROBLEMS

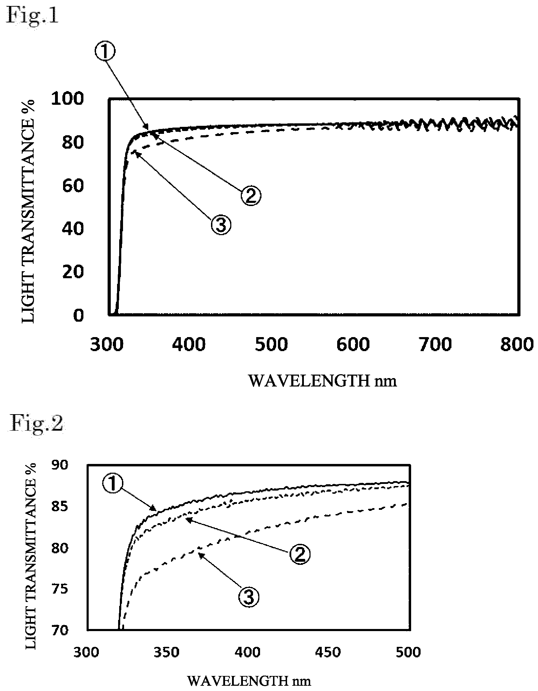

The present inventor has studied the light absorption coefficient obtained as a guideline for determining the degree of oxidation of aluminum oxide and the stability of the film on the basis of the total light transmittance, but has found that the absorption coefficient based on the spectral transmittance at a wavelength of 350 nm can be examined with higher sensitivity. Figs. 1 and 2 show spectral transmittance characteristics.
In Figs. 1 and 2, the light transmittance of a plastic film as a substrate of a transparent barrier film is indicated by "1". "3" indicates the light transmittance of the transparent barrier film immediately after an aluminum oxide layer is vapor-deposited, and "2" indicates the light transmittance in which oxidation of the aluminum oxide layer of the transparent barrier film of "3" further proceeds.
At a position of 350 nm, the light transmittance greatly differs depending on the degree of oxidation. At a wavelength of 500 nm or more, a change in light transmittance due to the degree of oxidation decreases.
It has been found that the stability of the aluminum oxide layer against an acid is related to the change in absorption coefficient at a wavelength of 350 nm. It has been found that a value of the absorption coefficient at a wavelength of 350 nm immediately after vapor-deposition and an absorption coefficient to which the absorption coefficient changes over time and finally reaches have a correlation, and the period of the change is related to the film thickness, thereby reaching the present invention.
That is, the present invention is a transparent gas barrier film including a plastic film having, on at least one surface of the plastic film, an aluminum oxide layer containing aluminum oxide as a main component, wherein an absorption coefficient of the aluminum oxide layer at a wavelength of 350 nm immediately after vapor-deposition is $8.0 \times 10^{-4}$ nm$^{-1}$ or more and $4.0 \times 10^{-3}$ nm$^{-1}$ or less, and an unchanged amount of the absorption coefficient is $3.0 \times 10^{-4}$ nm$^{-1}$ or less at a film thickness of 6 nm or more and 20 nm or less.
In the transparent gas barrier film, a film thickness is 12 nm or more.
In the transparent gas barrier film, a b value for transmission in a four-ply structure is 3 or less.

EFFECT OF THE INVENTION

The present invention makes it possible to provide a transparent gas barrier film that is inexpensive, has excellent transparency, can retain barrier properties even when packaging acidic contents, and can store the contents for a long period of time.

BRIEF DESCRIPTION OF THE DRAWINGS

Fig. 1 shows transmittance wavelength characteristics of a substrate plastic film and a transparent gas barrier film measured by a spectrophotometer.
Fig. 2 shows transmittance wavelength characteristics of a substrate plastic film and a transparent gas barrier film measured by a spectrophotometer (enlarged view).
Fig. 3 is a schematic view of a vapor-deposition apparatus.

MODE FOR CARRYING OUT THE INVENTION

Hereinafter, the present invention will be described in detail.

The present invention is a transparent gas barrier film including a plastic film having, on at least one surface of the plastic film, an aluminum oxide layer containing aluminum oxide as a main component, wherein an absorption coefficient of the aluminum oxide layer at a wavelength of 350 nm immediately after vapor-deposition is $8.0 \times 10^{-4}$ nm$^{-1}$ or more and $4.0 \times 10^{-3}$ nm$^{-1}$ or less, and an unchanged amount of the absorption coefficient is $3.0 \times 10^{-4}$ nm$^{-1}$ or less at a film thickness of 6 nm or more and 20 nm or less.

The aluminum oxide layer composed of aluminum oxide as a main component as used in the present invention substantially contains 99% or more of aluminum oxide and other components as impurities. The aluminum oxide contains not only a stoichiometrically complete oxide but also aluminum oxide that is deficient in oxygen.

In the transparent gas barrier film of the present invention, an oxygen transmission rate (OTR) is preferably 10 cc/m$^2$ atm day or less by a measurement method according to JIS K 7126-2, and a water vapor transmission rate (WVTR) is preferably 10 g/m$^2$ day or less by a measurement method according to Method B of JIS K 7126. More preferably, OTR is 5 cc/m$^2$ atm day or less and WVTR is 5 g/m$^2$ day or less. More preferably, OTR is 2 cc/m$^2$ atm day or less and WVTR is 2 g/m$^2$ day or less.

When the spectral transmittance of the aluminum oxide layer at a wavelength of 350 nm is Tal% and the film thickness of the aluminum oxide layer is tal nm, an absorption coefficient $\alpha$ as used in the present invention can be represented by Formula 1.

[Math 1]

$$\alpha = -1/tal \cdot \ln(Tal/100) \qquad --- \text{(Formula 1)}$$

When the spectral transmittance of the transparent gas barrier film having the aluminum oxide layer at a wavelength of 350 nm is T0% and the spectral transmittance of the substrate plastic film on which the aluminum oxide layer is laminated at a wavelength of 350 nm is Tb%, the spectral transmittance Tal% of the aluminum oxide layer at a wavelength of 350 nm can be represented by Formula (2).

[Math 2]

$$Tal = T0/Tb \times 100 \qquad --- \text{(Formula 2)}$$

As a premise, the reflectance on the surface is assumed to be equal.

The film thickness of the aluminum oxide layer of the present invention is a value determined by a fluorescent X-ray apparatus with the density of the aluminum oxide thin film being 0.74 times (2.94 g/cm$^3$) a bulk density (3.97 g/cm$^3$). The reason why the density of the aluminum oxide thin film is 0.74 times the bulk density is that the film thickness is well matched with an actual film thickness obtained by TEM or the like.

In order to obtain the film thickness using the fluorescent X-ray apparatus, it is necessary to measure a sample having a known film thickness in advance using the fluorescent X-ray apparatus, obtain a fluorescent X-ray dose emitted from the sample, and create a calibration curve of the film thickness and fluorescent X-ray intensity.

In a sample used for creating a calibration curve of fluorescent X-rays, an aluminum adhesion amount per unit area is identified by inductively coupled plasma emission spectroscopy, and the aluminum adhesion amount is converted into a film thickness by the density of an aluminum oxide thin film, to measure the film thickness.

The spectral transmittance at a wavelength of 350 nm as used in the present invention refers to a transmittance at a wavelength of 350 nm measured according to JIS K 0115:2020. In an optical film thickness meter installed to measure a film thickness in a vapor-deposition apparatus, a light source such as a mercury lamp or an LED having a light intensity in the vicinity of 350 nm is used to make light incident on one surface to be measured, and a value obtained by measuring an amount of light emitted from the other by a light receiver having sensitivity in the vicinity of 350 nm can also be used in accordance with the light transmittance at 350 nm by being calibrated with a sample in which the transmittance at a wavelength of 350 nm measured according to JIS K 0115:2020 is measured.

A b value for transmission as used in the present invention refers to the b value in the Lab display of the color space of Hunter when the light transmitted at the time of irradiation with the standard light C in JIS Z 8720 is viewed at a sensitivity of a viewing angle of 2 degrees.

The term "immediately after vapor-deposition" as used in the present invention refers to immediately after the aluminum oxide layer is vapor-deposited on the plastic film in a vacuum chamber, but substantially refers to the time when the roll film is taken out of the vacuum chamber. When the vapor-deposited aluminum oxide layer comes into contact with oxygen, the oxidation of the aluminum oxide layer proceeds, which causes change in the light transmittance. However, since the roll film taken out of the vacuum chamber does not contain air between the films and is wound with the transparent gas barrier film, oxidation does not proceed for a long time unless the film is pulled out from the roll. Therefore, if the film is pulled out from a state of being left as a roll for 1 or 2 days after vapor-deposition and measured, there is substantially no problem. Hereinafter, it is referred to as an initial absorption coefficient.

After the aluminum oxide layer comes into contact with oxygen, the degree of oxidation gradually increases, and the light absorption coefficient at a wavelength of 350 nm decreases. However, as a result of intensive studies, it has been found that the initial absorption coefficient and an absorption coefficient when the degree of oxidation of the aluminum oxide layer gradually increases and the value of the spectral transmittance at a wavelength of 350 nm does not change (referred to as a final absorption coefficient hereinafter) are related by a linear function as shown in Formula 3.

The initial absorption coefficient is denoted as $\alpha i$, and the final absorption coefficient is denoted as $\alpha f$.

[Math 3]

$$\alpha f = 0 \quad \alpha i < 1.0 \times 10^{-3} \qquad \text{---- (Formula 3)}$$

$$\alpha f = a \times \alpha i + b \quad \alpha i \geqq 1.0 \times 10^{-3}$$

$$a = 0.462, \quad b = -4.6 \times 10^{-4}$$

When vapor-deposition is not performed so that the initial absorption coefficient is $8.0 \times 10^{-4}$ nm$^{-1}$ or more, a water vapor transmission rate (WVTR) increases and the barrier performance deteriorates. This is considered to be because the aluminum oxide layer becomes rough when a large amount of oxygen is introduced during vapor-deposition so that the absorption coefficient is $8.0 \times 10^{-4}$ nm$^{-1}$ or less. When the initial absorption coefficient is $4.0 \times 10^{-3}$ nm$^{-1}$ or more, even when the aluminum oxide layer comes into contact with oxygen to be oxidized, a large amount of unoxidized metal aluminum atoms remain, and the unoxidized metal aluminum atoms are dissolved by the acid to increase the WVTR.

A period during which the aluminum oxide layer changes from the initial absorption coefficient to the final absorption coefficient depends on a film thickness t of the aluminum oxide layer. It has been found that approximation can be made by Formula 4 when an absorption coefficient after d days has elapsed is denoted as $\alpha d$.

[Math 4]

$$\alpha_d = \frac{\alpha_i - \alpha_f}{((a_d \times d^2 + b_d \times d)/(a_t \times t^2 + b_t \times t + c_t) + 1)} + \alpha_f \quad \text{--- (Formula 4)}$$

$$ad = 0.0538, \quad bd = 10.731 \quad at = 0.159, \quad bt = 0.151, \quad ct = 0.143$$

Here, the remaining absorption coefficient change $\Delta\alpha_d$ after d days (referred to as an unchanged amount of the absorption coefficient) is shown in Formula 5.

[Math 5]

$$\triangle\alpha_d = \frac{\alpha_i - \alpha_f}{((a_d \times d^2 + b_d \times d)/(a_t \times t^2 + b_t \times t + c_t) + 1)} \quad \text{--- (Formula 5)}$$

When the film thickness of the aluminum oxide layer is large, diffusion of oxygen is slow, and the unchanged amount of the absorption coefficient is $3.0 \times 10^{-4}$ nm$^{-1}$ or less, which requires about 2 weeks at 10 nm and 6 weeks at 20 nm.

It is estimated that when the unchanged amount of the absorption coefficient is large, the number of metal aluminum atoms increases, the metal aluminum atoms are dissolved in an acid to increase the WVTR.

Therefore, the initial absorption coefficient is preferably $8.0 \times 10^{-4}$ nm$^{-1}$ or more and $4.0 \times 10^{-3}$ nm$^{-1}$ or less. It is preferable that the unchanged amount of the absorption coefficient is $3.0 \times 10^{-4}$ nm$^{-1}$ or less in an environment at normal temperature or higher by bringing the transparent barrier film having the aluminum oxide layer after vapor-deposition into contact with oxygen by winding back or the like.

The acid resistance as used in the present invention means that an aluminum oxide layer as a barrier layer does not lose its barrier properties due to chemical change in the aluminum oxide layer caused by acids when highly acidic contents are put in a package including a transparent barrier film.

The thickness of the aluminum oxide layer of the transparent barrier film of the present invention is preferably 6 nm or more. When the thickness is less than 6 nm, the barrier properties are problematic. The thickness is more preferably 12 nm or more. When the thickness is less than 12 nm, a ratio of a layer having a problem of barrier properties to the total film thickness is large, so that acid resistance is slightly poor.

The thickness of the aluminum oxide layer of the transparent barrier film of the present invention is preferably 20 nm or less. When the thickness is 20 nm or more, it takes a long time for the unchanged amount of the absorption coefficient to be $3.0 \times 10^{-4}$ nm$^{-1}$ or less.

Measurement is performed by stacking four sheets of the transparent barrier film of the present invention in order to clearly read the value, and when the b value in a four-ply structure is 3 or more, a white print layer becomes slightly yellowish and color development deteriorates. The b value is preferably 3 or less in the four-ply structure of the transparent barrier films of the present invention.

As a method for producing a transparent barrier film having an aluminum oxide layer of the present invention, a reactive vapor-deposition method is suitable. The reactive vapor-deposition method is a method in which oxygen is introduced into a vapor-deposition tank where metal aluminum is evaporated by heating, to oxidize the metal aluminum, thereby depositing aluminum oxide on a substrate plastic film. As a method for evaporating metal aluminum by heating, a resistance heating method, an induction heating method, and an electron beam heating method can be used.

Examples of a method for controlling the film thickness include a method in which an aluminum oxide layer deposited on a plastic film is measured with a film thickness meter using fluorescent X-rays, and the heating is adjusted to control the film thickness in comparison with the target film thickness. In this case, in order to set the absorption coefficient to $8.0 \times 10^{-4}$ nm$^{-1}$ or more and $4.0 \times 10^{-3}$ nm$^{-1}$ or less, a photometer that irradiates light from one side of the plastic film and measures light transmitted from the other side is installed, to control the amount of oxygen introduced according to the amount of the total transmission light. The light to be irradiated has a sufficient light amount at a wavelength of 350 nm, and the photometer also preferably has a sufficient sensitivity at 350 nm.

Alternatively, metal aluminum is first vapor-deposited on the substrate plastic film. The thickness of the deposited metal aluminum is controlled by an optical film thickness meter that irradiates light from one side of the plastic film after vapor-deposition and measures light transmitted from the other side to convert the measured value into a film thickness, thereby making the film thickness constant. Thereafter, oxygen is introduced to deposit aluminum oxide so as to achieve a target transmittance. Next, the introduction amount of oxygen is fixed to be constant. When the evaporation amount decreases, the film thickness decreases and the ratio of oxygen with respect thereto increases, so that the light transmission amount increases. There is a production method in which an optical film thickness meter is used to control the evaporation amount so that the light transmittance becomes a target light transmittance. The latter production method is preferable because the apparatus is simple.

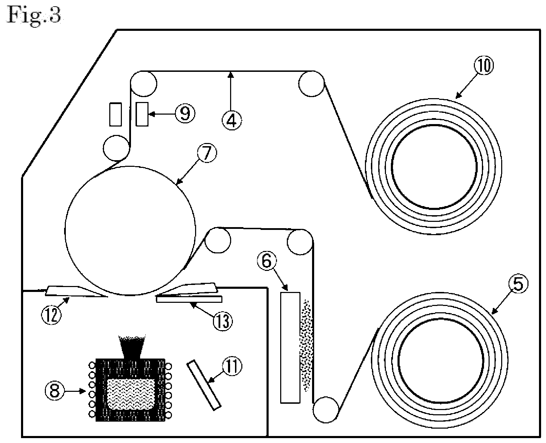

A method for producing a transparent barrier film will be described with reference to Fig. 3 of a schematic view of an induction heating type roll-to-roll vapor-deposition apparatus that heats a carbon crucible generally used in aluminum vapor-deposition by an induction current to perform evaporation.

A substrate plastic film (4) is put in a vacuum chamber as an unwinding roll (5). The plastic film (4) is unwound from the unwinding roll (5), a vapor-deposition surface of the plastic film (4) is treated by a flat electrode-type plasma source (6), and the plastic film (4) is guided to a coating roll (7). The coating roll (7) is kept at a low temperature of about -10°C to prevent an increase in temperature of the plastic film (4) due to radiant heat from a vapor-deposition source (crucible) (8) and latent heat of aluminum oxide vapor.

After the aluminum oxide layer is formed on the plastic film (4) on the coating roll, the plastic film (4) moves to an optical film thickness meter (9) including a light source having a light radiation intensity of 350 nm and a light receiver having light receiving sensitivity, and the light transmittance is measured. After the light transmittance is measured, the plastic film is wound around a winding roll.

The evaporation amount of aluminum is adjusted by adjusting the AC power flowing through a coil wound around the vapor-deposition source (crucible) (8) such that there is no difference in the light transmittance of the plastic film (4) measured by the optical film thickness meter (9) as compared with a target value. The vapor-deposition source (crucible) (8) is made of carbon and is heated by an induction current flowing in the carbon crucible induced by the coil wound around the vapor-deposition source (crucible).

The aluminum vapor evaporated from the vapor-deposition source (crucible) (8) reacts with oxygen gas introduced from an oxygen nozzle (11) installed so that oxygen is ejected along a flow of the aluminum vapor to deposit an aluminum oxide layer on the plastic film (4) on the coating roll (7). It is preferable that the range in which the oxygen gas is in contact with the aluminum vapor is expanded, and oxygen efficiently reacts with aluminum to reduce oxygen to be exhausted without being consumed. Unconsumed oxygen increases a pressure in a vacuum vapor-deposition tank. When vapor-deposition is performed in a situation where the pressure is high, the density of the formed film tends to decrease.

A coating window (12) is installed near the coating roll (7) in order to limit the angle of incidence of aluminum vapor on the plastic film (4) or to prevent the adhesion of aluminum to unnecessary places.

The transparent barrier film on which aluminum oxide is laminated is wound around a winding roll (10).

After the aluminum oxide layer is formed on the plastic film (4) having a predetermined length, a shutter (13) is closed, heating to the vapor-deposition source (crucible) (8) is stopped, the travel of the plastic film (4) is stopped, and the process is terminated.

After vapor-deposition, the plastic film is taken out in a roll form from the vapor-deposition apparatus. Since the plastic film is wound in a vacuum, there is no space between the films. Since the film is a barrier film, the internal aluminum oxide layer wound around the roll film is not exposed to the atmosphere.

Therefore, in order to set the unchanged amount of the absorption coefficient to $3.0 \times 10^{-4}$ nm$^{-1}$ or less, it is necessary to rewind the rolled plastic film once in the atmosphere to entrain air between layers of the plastic film. As a rewinding condition, it is preferable to rewind the plastic film under a condition that an air layer of 0.4 um or more is entrained. When the plastic film is rewound under a high-temperature high-humidity atmosphere, the plastic film after vapor-deposition may be blocked due to dew formation, whereby it is preferable that the temperature is 40°C or less, and the relative humidity is 70 RH% or less. The amount of air entrained can be represented by Formula 6. When the thickness of the rewound plastic film is t $\mu$m; the winding length thereof is l m; the diameter of a paper tube used is 2r mm; and the diameter of the wound plastic film roll is 2R mm, the thickness tair um of the layer of air entrained between the plastic films can be represented by Formula 6.

[Math 6]

$$\texttt{tair = π (R}^2\texttt{-r}^2\texttt{) / l·t} \quad \texttt{--- (Formula 6)}$$

In the rewound rolled plastic film, the oxidation of the aluminum oxide layer gradually proceeds. The rewound rolled plastic film is stored until the unchanged amount of the absorption coefficient $\Delta\alpha_d$ represented by Formula 5 becomes $3.0 \times 10^{-4}$ nm$^{-1}$ or less.

As a storage environment, normal temperature of 10°C to 40°C is desirable. When the temperature is too high, the physical properties and the like of the film may be affected.

As a guideline for the storage period, the storage period is about 1 week at a thickness of the aluminum oxide layer of 7 nm and is 1.5 months at a thickness of the aluminum oxide layer of 20 nm.

The plastic film as used in the present invention is a film obtained by melt-extruding an organic polymer, stretching the organic polymer in a machine direction and/or a transverse direction as necessary, and cooling and thermosetting the organic polymer. Examples of the organic polymer include polyethylene, polypropylene, polyethylene terephthalate, polyethylene-2,6-naphthalate, nylon 6, nylon 4, nylon 66, nylon 12, polyvinyl chloride, polyvinylidene chloride, polyvinyl alcohol, wholly aromatic polyamide, polyamide imide, polyimide, polyether imide, polysulfone, polyphenylene sulfide, and polyphenylene oxide. These organic polymers may be copolymerized or blended with a small amount of other organic polymers.

In relation to recent environmental problems, a plastic film obtained by partially or entirely using a resin regenerated from a discarded PET bottle or the like, and a plastic film using a biomonomer derived from a plant as a monomer raw material to be an organic polymer are also preferred.

Furthermore, to this organic polymer, known additives such as an ultraviolet absorber, an anti-static agent, a plasticizer, a lubricant, and a coloring agent may be added, and a plastic film having a total light transmittance of 70% or more is preferable from the viewpoint of the plastic film utilizing the transparency, but the transparency of the plastic film is not particularly limited. The total light transmittance is more preferably 80% or more. In particular, the light transmittance at 350 nm is preferably 50% or more from the viewpoint of management of the absorption coefficient of aluminum oxide at 350 nm.

The plastic film used in the present invention may be subjected to a corona discharge treatment, a glow discharge treatment, or other surface roughening treatment before laminating an aluminum oxide layer thereto, or may be subjected to a known anchor coating treatment. The thickness of the plastic film used in the present invention is preferably in the range of 5 to 1000 $\mu$m, and more preferably in the range of 7 to 50 $\mu$m.

The aluminum oxide layer of the present invention is relatively hard because the aluminum oxide layer has an increased density to provide improved barrier properties. Therefore, the plastic film preferably has good dimensional stability. An un-stretched plastic film cannot be said to be preferable because the un-stretched plastic film is apt to be deformed by tension. A polyamide film made of nylon or the like having a large dimensional change due to humidity or the like cannot be said to be also preferable.

It is preferable to use a biaxially stretched polyethylene terephthalate film or a biaxially stretched polypropylene film that has a small dimensional change due to humidity and temperature.

In the vapor-deposition step, the substrate plastic film is heated by radiant heat from the vapor-deposition source and heat dissipation accompanying the phase change of aluminum from a gas phase to a solid phase. From this viewpoint, a biaxially stretched film of polyethylene terephthalate having relatively excellent heat resistance is preferable.

EXAMPLES

Hereinafter, the present invention will be specifically described with reference to Examples, but the present invention is not limited to Examples.

A transparent barrier film was produced using a vapor-deposition apparatus of a boat-type resistance heating vapor-deposition source having an aluminum wire feeding mechanism instead of the vapor-deposition apparatus including an induction heating vapor-deposition source having a carbon crucible illustrated in the schematic view of Fig. 3 and the induction heating vapor-deposition source.

Each vapor-deposition apparatus is equipped with an optical film thickness meter, and the correlation with the light transmittance or total light transmittance at 350 nm is grasped.

In the vapor-deposition apparatus including an induction heating vapor-deposition source, the power of induction heating was adjusted to a target value by the optical film thickness meter.

In the resistance heating type vapor-deposition apparatus, the oxygen nozzle was installed near the coating roll, and the introduction amount of oxygen was adjusted to a target value by the optical film thickness meter.

As a substrate plastic film, a 12 $\mu$m-thick PET film subjected to a corona treatment on one side of a Toyobo ester (R) film was used. The aluminum oxide layer was vapor-deposited on the corona surface.

The spectral transmittance at 350 nm was measured with a spectrophotometer (Hitachi High-Tech Corporation, U-3010) according to JIS K 0115. An integrating sphere was used for the measurement.

The total light transmittance was measured with a turbidimeter (NIPPON DENSHOKU INDUSTRIES CO., LTD., NDH2000) according to JIS K 7375-1.

The b value in the four-ply structure of the transparent barrier films was measured with a color difference meter (NIPPON DENSHOKU INDUSTRIES CO., LTD., Z-300A) according to JIS Z 8722 under the conditions of a C light source and transmission at a viewing angle of 2°.

An oxygen transmission rate (OTR) was measured under measurement conditions of a temperature of 23°C and a humidity of 65%RH using an oxygen transmission measuring apparatus (OXTRAN-2/20 manufactured by MOCON Inc., US) according to JIS K 7126-2.

The water vapor transmission rate (WVTR) was measured under measurement conditions of a temperature of 40°C and a humidity of 90%RH using a water vapor transmission measuring apparatus (ERMATR_AN-W3/31 manufactured by MOCON Inc., US) according to JIS K 7129B.

Acid resistance was evaluated as follows.

First, a laminated film is formed by dry-laminating a linear low density polyethylene film (LLDEP: L4102 40 um, manufactured by Toyobo Co., Ltd.) on the formed transparent barrier film. For the dry lamination, an adhesive obtained by mixing TM569 and CAT-10L manufactured by Toyo-Morton, Ltd. was used.

The laminated film is cut into two A5 size films (148 mm $\times$ 210 mm). The two films are sealed at three sides in a state where the films L4012 are overlapped, to form a bag. A seal width is about 10 mm.

The bag is filled with 100 ml of a dilution obtained by diluting vinegar (manufactured by Mizukan, grain vinegar) to 50% with water, and sealed. The bag is stored in a room at 40°C. The bag stored for 1 week and the bag stored for 3 weeks were taken out, and the oxygen transmission rate was measured and evaluated. In the bag filled with the vinegar, the contents were taken out by cutting off one seal portion, washed with water and dried, and then the remaining three seals were cut off and returned to the laminated film. The oxygen transmission rate of this laminated film was measured and compared with the oxygen transmission rate of the untreated laminated film to evaluate the acid resistance.

(Example 1)

A transparent barrier film was produced using an induction vapor-deposition apparatus. This apparatus does not have a mechanism for plasma-treating the vapor-deposition surface of the plastic film illustrated in Fig. 3. The oxygen nozzle was installed near the vapor-deposition source.

A PET film having a light transmittance at 350 nm of 85% was set in a vapor-deposition apparatus, and an optical film thickness meter was calibrated to be 100%. First, aluminum was evaporated without adding oxygen so that the indicated value of the optical film thickness meter was 14% (Aluminum in optical film thickness meter in Table 1). After the evaporation of aluminum was stabilized, the amount of introduced oxygen was adjusted so that the indicated value of the optical film thickness meter was 95% (Aluminum oxide in optical film thickness meter in Table 1). The introduction amount of oxygen gas at this time was 300 sccm. A pressure in a vapor-deposition chamber after the introduction of the oxygen was 5.1 × 10-2 Pa. Table 1 shows the conditions of Example 1.

The produced transparent barrier film was cut into a sheet, the transmittance was measured using a spectrophotometer, the film thickness was measured using a fluorescent X-ray apparatus, and the initial absorption coefficient was calculated.

After the transparent barrier film was stored for a certain period of time, the barrier was measured, and the transmittance was measured again using the spectrophotometer. The absorption coefficient was calculated from the measured transmittance, and the unchanged amount was calculated.

Table 2 shows the absorption coefficient, the b value, and the film thickness.

After storage for a certain period of time, the transparent barrier film was laminated to produce a bag, and the acid resistance was evaluated. Table 3 shows the results of barrier properties and acid resistance.

[Table 1]

| | Apparatus | Raw material width | Optical film thickness meter indicated value | | Processing rate | Oxygen gas introduction amount | Pressure |
|---|---|---|---|---|---|---|---|
| | | | Aluminum % | Aluminum oxide % | | | |
| | | mm | | | m/min | sccm | Pa |
| Example 1 | Induction | 210 | 14 | 95 | 15 | 300 | 0.0507 |
| Example 2 | Induction | 210 | 14 | 87 | 15 | 280 | 0.0507 |
| Example 3 | Induction | 210 | 14 | 91 | 15 | 290 | 0.0507 |
| Example 4 | Induction | 210 | 27 | 97 | 24 | 220 | 0.0587 |
| Comparative Example 1 | Induction | 210 | 23 | 96 | 18 | 340 | 0.0547 |
| Comparative Example 2 | Induction | 210 | 27 | 92 | 24 | 230 | 0.0587 |
| Comparative Example 3 | Induction | 210 | 7 | 97 | 27 | 690 | 0.0427 |
| Comparative Example 4 | Resistance | 2000 | 39 | 72 | 600 | 12278 | 0.0015 |
| Comparative Example 5 | Resistance | 2000 | 18 | 69 | 333 | 13786 | 0.0014 |

[Table 2]

| | Absorption coefficient at 350 nm | | Total light absorption coefficient | | b value elapse | Film thickness |
|---|---|---|---|---|---|---|
| | Initial value nm-1 | Unchanged amount nm-1 | Initial value nm-1 | After 3 weeks nm-1 | | nm |
| Example 1 | 0.001083 | 0.000105 | 0 | 0 | 1.9 | 17 |
| Example 2 | 0.002295 | 0.000193 | 0.000012 | 0.000012 | 2.1 | 19 |
| Example 3 | 0.002354 | 0.000188 | 0 | 0 | 2.0 | 18 |
| Example 4 | 0.000994 | 0.000028 | 0.000120 | 0.000024 | 2.2 | 10 |
| Comparative Example 1 | 0.000719 | 0.000085 | 0.000055 | 0 | 1.9 | 17 |
| Comparative Example 2 | 0.004542 | 0.000106 | 0.000903 | 0.000209 | 2.2 | 11 |
| Comparative Example 3 | 0.001104 | 0.000328 | 0.000046 | 0 | 1.7 | 23 |
| Comparative Example 4 | 0.004658 | 0.000007 | 0.027337 | 0.000590 | 2.2 | 6 |

(continued)

| | Absorption coefficient at 350 nm | | Total light absorption coefficient | | b value elapse | Film thickness |
|---|---|---|---|---|---|---|
| | Initial value $nm^{-1}$ | Unchanged amount $nm^{-1}$ | Initial value $nm^{-1}$ | After 3 weeks $nm^{-1}$ | | nm |
| Comparative Example 5 | 0.007559 | 0.000025 | 0.021829 | 0.000000 | 3.0 | 10 |

[Table 3]

| | OTR cc/m$^2$ atm day | WVTR g/m$^2$ day | Acid resistance test OTR cc/m$^2$ atm day | | |
|---|---|---|---|---|---|
| | | | Untreated | After 1 week | After 3 weeks |
| Example 1 | 2.9 | 1.6 | 2.9 | 1.5 | 2.0 |
| Example 2 | 2.3 | 1.4 | 2.3 | 1.3 | 1.2 |
| Example 3 | 2.2 | 1.5 | 2.2 | 1.4 | 1.6 |
| Example 4 | 2.2 | 1.7 | 2.2 | 2.0 | 11.3 |
| Comparative Example 1 | 3.6 | 2.4 | 1.5 | 1.8 | 1.4 |
| Comparative Example 2 | 1.9 | 1.7 | 1.9 | 1.6 | 29.8 |
| Comparative Example 3 | 2.8 | 1.4 | 2.8 | 1.3 | 42.0 |
| Comparative Example 4 | 2.6 | 0.8 | 2. 6 | 7.7 | 84.6 |
| Comparative Example 5 | 3.2 | 0.9 | 3.1 | 4.3 | 87.6 |

Examples 2 to 4 and Comparative Examples 1 to 3

A transparent barrier film was produced under the conditions shown in Table 1 in the same manner as in Example 1. Table 2 shows the absorption coefficient and the like. Table 3 shows the results of barrier properties and acid resistance.

Comparative Examples 4 and 5

A transparent barrier film was produced using a large-sized vapor-deposition apparatus having a resistance heating vapor-deposition source. This apparatus had a mechanism for plasma-treating the vapor-deposition surface of the plastic film and was used. Oxygen gas was supplied from the vicinity of the coating roll. A transparent barrier film was produced under the conditions shown in Table 1 according to Example 1. Table 2 shows the absorption coefficient and the like. Since the optical film thickness meter of the resistance heating vapor-deposition apparatus performed measurement based on the total light transmittance, the initial absorption coefficient was obtained from the current absorption coefficient at 350 nm by using Formula 3.

Table 3 shows the results of barrier properties and acid resistance.

In Comparative Example 1, since the initial absorption coefficient is slightly lower than that in Examples, the WVTR is slightly higher.

In Comparative Examples 2, 4, and 5, the initial absorption coefficient is large, and the barrier properties after 3 weeks are deteriorated.

In Comparative Example 3, the unchanged amount of the absorption coefficient is high, and the film thickness is thick, so that the barrier properties after 3 weeks are deteriorated.

INDUSTRIAL APPLICABILITY

The present invention makes it possible to provide a transparent barrier film that includes, as a barrier layer, an aluminum oxide layer that can be produced at a low cost to have excellent acid resistance and be capable of packaging a wide range of contents.

DESCRIPTION OF REFERENCE SIGNS

1 Light transmittance wavelength characteristics of substrate plastic film (12 $\mu$m-thick PET film)
2 Light transmittance wavelength characteristics of transparent gas barrier film on which aluminum oxide layer with advanced oxidation is laminated
3 Light transmittance wavelength characteristics of transparent gas barrier film on which aluminum oxide layer immediately after vapor-deposition is laminated
4 Plastic film
5 Unwinding roll
6 Plasma source
7 Coating roll
8 Vapor-deposition source (crucible)
9 Optical film thickness meter
10 Winding roll
11 Oxygen nozzle
12 Coating window
13 Shutter

**Claims**

1. A transparent gas barrier film comprising a plastic film having, on at least one surface of the plastic film, an aluminum oxide layer containing aluminum oxide as a main component,

   wherein an absorption coefficient of the aluminum oxide layer at a wavelength of 350 nm immediately after vapor-deposition is $8.0 \times 10^{-4}$ nm$^{-1}$ or more and $4.0 \times 10^{-3}$ nm$^{-1}$ or less, and
   an unchanged amount of the absorption coefficient is $3.0 \times 10^{-4}$ nm$^{-1}$ or less at a film thickness of 6 nm or more and 20 nm or less.

2. The transparent gas barrier film according to claim 1, wherein a film thickness is 12 nm or more.

3. The transparent gas barrier film according to claim 1 or 2, wherein a b value for transmission in a four-ply structure is 3 or less.

Fig.1

Fig.2

Fig.3

| | INTERNATIONAL SEARCH REPORT | International application No. |
|---|---|---|
| | | **PCT/JP2023/013294** |

**A. CLASSIFICATION OF SUBJECT MATTER**

***B32B 9/00***(2006.01)i; ***C23C 14/08***(2006.01)i
FI: B32B9/00 A; C23C14/08 A

According to International Patent Classification (IPC) or to both national classification and IPC

**B. FIELDS SEARCHED**

Minimum documentation searched (classification system followed by classification symbols)

B32B1/00-43/00;C23C14/00-14/58

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-199515 A (DAINIPPON PRINTING CO LTD) 28 July 2005 (2005-07-28) claims, paragraphs [0006]-[0007], [0036]-[0052], examples 1, 3, fig. 1-2 | 1-3 |
| Y | JP 2003-105528 A (TOHCELLO CO LTD) 09 April 2003 (2003-04-09) claims, paragraphs [0006], [0017]-[0018] | 1-3 |
| A | WO 2020/241621 A1 (TOYOBO CO., LTD.) 03 December 2020 (2020-12-03) | 1-3 |
| A | JP 2021-98283 A (TORAY INDUSTRIES) 01 July 2021 (2021-07-01) | 1-3 |
| A | JP 2018-65900 A (TORAY ADVANCED FILM CO LTD) 26 April 2018 (2018-04-26) | 1-3 |

☐ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 June 2023** | **27 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/013294**

| Patent document cited in search report | | | Publication date (day/month/year) | Patent family member(s) | | | Publication date (day/month/year) |
|---|---|---|---|---|---|---|---|
| JP | 2005-199515 | A | 28 July 2005 | (Family: none) | | | |
| JP | 2003-105528 | A | 09 April 2003 | EP claims, paragraphs [0007]-[0008], [0054]-[0055] | 1298229 | A1 | |
| | | | | KR 10-2003-0026879 | | A | |
| | | | | CN | 1408896 | A | |
| WO | 2020/241621 | A1 | 03 December 2020 | US | 2022/0220602 | A1 | |
| | | | | EP | 3978235 | A1 | |
| | | | | CN | 113874543 | A | |
| | | | | KR 10-2022-0016165 | | A | |
| | | | | CA | 3141710 | A | |
| | | | | TW | 202120725 | A | |
| JP | 2021-98283 | A | 01 July 2021 | (Family: none) | | | |
| JP | 2018-65900 | A | 26 April 2018 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 02638797 B
- JP 2007290292 A
- JP 2007002325 A
- WO 2020241621 A